Europäisches Patentamt

European Patent Office

Office européen des brevets

(19)

(11) **EP 0 874 429 A1**

## (12) DEMANDE DE BREVET EUROPEEN

(43) Date de publication:
**28.10.1998 Bulletin 1998/44**

(51) Int Cl.6: **H01S 3/25**, H01S 3/085

(21) Numéro de dépôt: **98400933.2**

(22) Date de dépôt: **15.04.1998**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **21.04.1997 FR 9704898**

(71) Demandeur: **FRANCE TELECOM**
**75015 Paris (FR)**

(72) Inventeur: **Menigaux, Louis**
**91440 Bures sur Yvette (FR)**

(74) Mandataire: **Plaçais, Jean-Yves**
**Cabinet Netter,**
**40, rue Vignon**
**75009 Paris (FR)**

### (54) Procédé de fabrication d'un dispositif semi-conducteur à réseau de Bragg de pas constant

(57) Sur un substrat semiconducteur (1) muni de marches, on fait croître un empilement de couples de couches semiconductrices de confinement (5) et active (6), les couches actives possédant des énergies de bande interdite différentes d'un couple à l'autre. Puis, on planarise l'empilement en un niveau choisi pour y créer localement des zones (8) d'indices optiques effectifs différents choisis, sensiblement parallèles entre elles. On dépose alors une couche semiconductrice terminale de confinement (9) dans laquelle on réalise, au niveau d'une partie au moins d'une première zone choisie, un réseau de diffraction (10) de pas choisi et parallèle aux bords des marches, de sorte que la partie de la première zone émette à une première longueur d'onde fonction de son indice optique effectif. Enfin, on dépose sur la couche terminale au moins une première ligne de propagation (11-1) présentant au moins au dessus de la partie de la zone choisie une direction sensiblement perpendiculaire au réseau de diffraction (10).

FIG.5

## Description

L'invention concerne les dispositifs semiconducteurs susceptibles d'applications en optoélectronique, et notamment ceux capables d'effet laser.

De tels dispositifs sont notamment utilisés dans le domaine des télécommunications où il est fréquemment nécessaire d'intégrer plusieurs fonctions optiques, différentes ou non, dans des composants de très petites dimensions. On entend ici par fonctions optiques une émission stimulée de type laser, un guidage de lumière, un couplage de lumières de longueurs d'onde différentes, etc.

On connaît déjà, d'après la publication FR 2 713 350 des dispositifs semiconducteurs comportant localement des zones parallèles d'indices optiques effectifs différents couplées à des réseaux de diffraction perpendiculaires à l'axe d'alignement des zones, pour permettre des émissions laser de longueurs d'onde différentes parallèlement audit axe d'alignement. Ces dispositifs sont formés par empilement de couples de couches semiconductrices actives et de confinement. Les variations locales d'indice optique effectif sont obtenues par un contrôle au niveau de chaque zone du nombre de couples de couches de confinement et active.

De tels dispositifs forment des barrettes de lasers multilongueurs d'onde, plus connues sous les acronymes anglais DBR et DFB (respectivement pour "Distributed Bragg Reflector" et "Distributed Feed Back").

Les procédés de fabrication de ces types de dispositifs font appel à des technologies difficiles à mettre en oeuvre et dont les résultats, loin d'être parfaits, entraînent des limitations des performances, notamment.

Par ailleurs, dans ces dispositifs, les lignes de propagation sont formées au dessus des zones, parallèlement à l'axe d'alignement. En conséquence, une zone ne peut assurer qu'une unique fonction. Elle sera soit guide de lumière si elle n'est pas couplée à un réseau, soit susceptible d'effet laser dans le cas contraire. En conséquence, pour transmettre l'émission laser d'une ligne de propagation à un guide de lumière, il faut deux dispositifs (ou composants), munis respectivement d'une face clivée ou d'un miroir dont la réalisation est difficile.

De plus, en raison de la divergence de l'émission laser en sortie d'une face clivée, un contrôle très précis de la distance (environ 1 $\mu m$) entre les composants à coupler doit être effectué si l'on veut limiter les pertes de lumière.

Un but de l'invention est donc de procurer un procédé de fabrication d'un dispositif semiconducteur du type décrit en introduction qui ne présente pas tout ou partie des inconvénients précités.

L'invention propose à cet effet un procédé comprenant la combinaison des étapes suivantes :

- réaliser dans un substrat semiconducteur une multiplicité de marches, de dimensions adaptées, munies de faces supérieures parallèles entre elles et reliées entre elles par des bords sensiblement perpendiculaires aux faces supérieures,

- faire croître sur le substrat muni des marches, en une première épitaxie, un empilement d'au moins des premier et second couples de couches semiconductrices de confinement et active, dans cet ordre, les couches actives possédant des énergies de bande interdite différentes d'un couple à l'autre,

- planariser l'empilement en un niveau choisi de façon à former une surface supérieure plane, sensiblement parallèle aux faces supérieures des marches, et à créer localement dans l'empilement des zones d'indices optiques effectifs différents choisis, sensiblement parallèles entre elles et respectivement superposables aux faces supérieures des marches,

- faire croître sur la surface supérieure, en une seconde épitaxie, une couche semiconductrice terminale de confinement, de type p,

- réaliser dans la couche terminale de confinement, au niveau d'une partie au moins d'une première zone choisie, un réseau de diffraction de pas choisi et parallèle aux bords des marches, de sorte que ladite partie de la première zone soit susceptible d'effet laser à une première longueur d'onde fonction de son indice optique effectif, et

- déposer sur la couche terminale au moins une première ligne de propagation présentant au moins au dessus de la partie de la zone choisie une direction sensiblement perpendiculaire au réseau de diffraction (on entend ici par "sensiblement", une direction qui peut être perpendiculaire à environ plus ou moins 8°).

Ainsi, une partie d'une zone couplée à un réseau de diffraction sert à l'émission laser à une première longueur d'onde dépendant notamment de l'indice optique effectif du matériau sous-jacent, tandis qu'une autre partie de cette même zone, sans réseau, peut servir à guider un autre faisceau de lumière de longueur d'onde supérieure à la première.

Préférentiellement, le réseau de diffraction est un réseau dit "de Bragg".

Avantageusement, au moins la première épitaxie est réalisée en phase vapeur, de type MOCVD (pour Metal Oxyde Chemical Vapor Deposition), ce qui permet un contrôle de qualité des caractéristiques des couches, et par conséquent un très bon contrôle des performances et longueurs d'onde de fonctionnement des dispositifs.

De façon également préférentielle, la planarisation s'effectue par attaques chimiques sélectives des couches de confinement et des couches actives. Ainsi, une première solution va attaquer la couche active la plus éloignée du substrat, puis une seconde solution attaquera la couche de confinement située en dessous de cette couche active, puis on attaquera éventuellement la couche active suivante avec la première solution, et ainsi de suite jusqu'au niveau choisi pour la formation de la surface supérieure. Bien entendu, on fait appel à des masques pour protéger certaines parties de couches lors des attaques successives.

Selon une autre caractéristique de l'invention, les couches actives présentent respectivement des énergies de bande interdite qui sont d'autant plus petites que la distance qui les sépare du substrat est grande.

Ainsi, la zone qui suit une première zone susceptible d'effet laser à une première longueur d'onde présente un indice optique effectif plus petit que celui de la première zone, ce qui lui permet d'être transparente à la première longueur d'onde et par conséquent de la guider. On réalise de la sorte un dispositif qui intègre en même temps, et sans couplage de composants différents, deux fonctions différentes.

Préférentiellement, les couches de confinement des paires de couches sont de type n, et réalisées dans un matériau binaire, de type InP. De même, il est préférable que les couches actives soient réalisées dans un matériau quaternaire accordé en maille avec le matériau formant les couches de confinement et dont les proportions respectives des quatre constituants varient d'une paire à l'autre de façon à permettre des effets laser à des longueurs d'onde différentes. Ce matériau quaternaire pourra être de type GaInAsP.

Le substrat est réalisé dans un matériau binaire qui est de préférence identique à celui utilisé pour les couches de confinement.

L'invention ne se limite pas à la réalisation de dispositifs émettant seulement sur une unique longueur d'onde. Le procédé permet en effet de réaliser des dispositifs à la fois multilongueurs d'onde et guides de lumière. Pour ce faire, il faut à la fois prévoir un nombre de couples de couches suffisant à la génération des différentes longueurs d'onde, et réaliser le réseau de diffraction en autant de parties de zones différentes, non contiguës et non alignées selon la direction perpendiculaire aux bords de marches, qu'il y a de longueurs d'onde prévues.

Dans la description qui suit, faite à titre d'exemple, on se réfère aux dessins annexés, sur lesquels :

- la figure 1 illustre schématiquement la première étape du procédé selon l'invention, dite de réalisation du substrat;

- les figures 2A et 2B illustrent schématiquement la seconde étape du procédé selon l'invention, dite de croissance des couples de couches;

- la figure 3 illustre schématiquement la troisième étape du procédé selon l'invention, dite de planarisation;

- la figure 4 illustre schématiquement la quatrième étape du procédé selon l'invention, dite de croissance de la couche de type p;

- la figure 5 illustre schématiquement, sur un exemple de dispositif optoélectronique, les cinquième et sixième étapes du procédé selon l'invention, dites respectivement de formation du réseau de diffraction et de formation des lignes de propagation; et

- la figure 6 illustre, dans une vue du dessus, une partie du dispositif de la figure 5, détaillant les résultats des cinquième et sixième étapes du procédé selon l'invention.

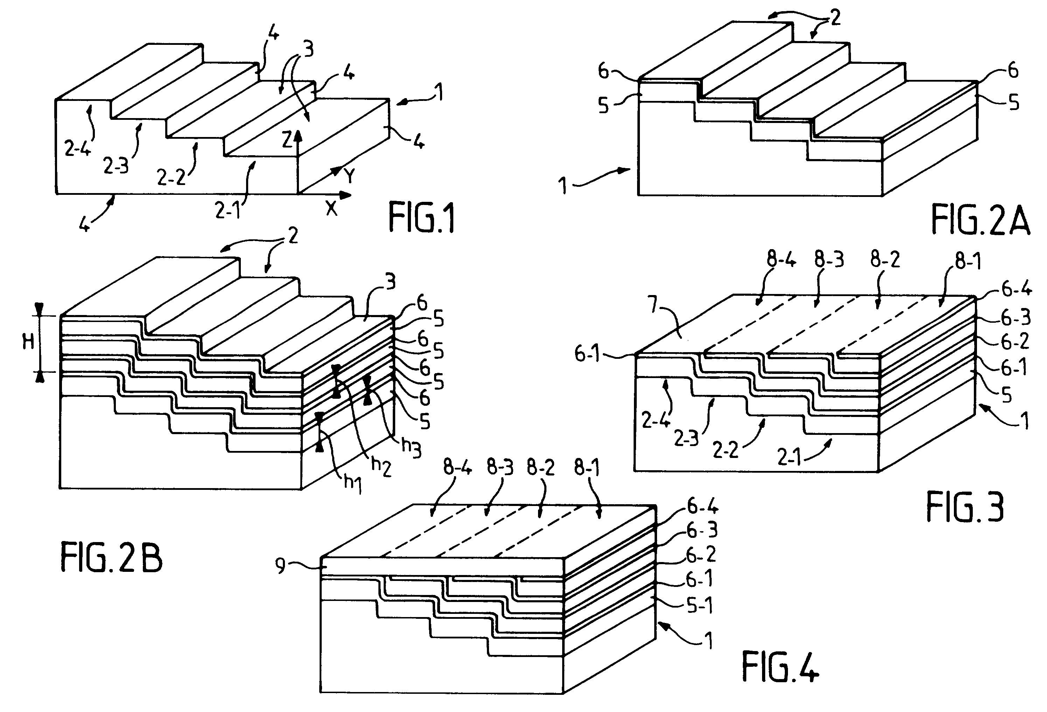

On se réfère tout d'abord aux figures 1 à 4 pour décrire les quatre premières étapes du procédé selon l'invention, destiné à réaliser des dispositifs optoélectroniques à base de semiconducteurs. De tels dispositifs sont plus particulièrement adaptés au domaine des télécommunications, mais il est clair que tous les autres domaines utilisant des dispositifs optoélectroniques à émission laser sont également concernés par l'invention.

Le procédé selon l'invention comprend un certain nombre d'étapes qui sont, prises séparément les unes des autres, connues de l'homme de l'art. Il est donc inutile d'en décrire la mise en oeuvre générale.

Ces étapes sont certes classiques, mais elles dépendent bien évidemment, dans le détail, du composant (ou dispositif) à réaliser. En d'autres termes, comme on le verra plus loin, la mise en oeuvre de certaines étapes (notamment les étapes 1, 2, 5 et 6) dépend des fonctions que doit assurer le dispositif (ou composant).

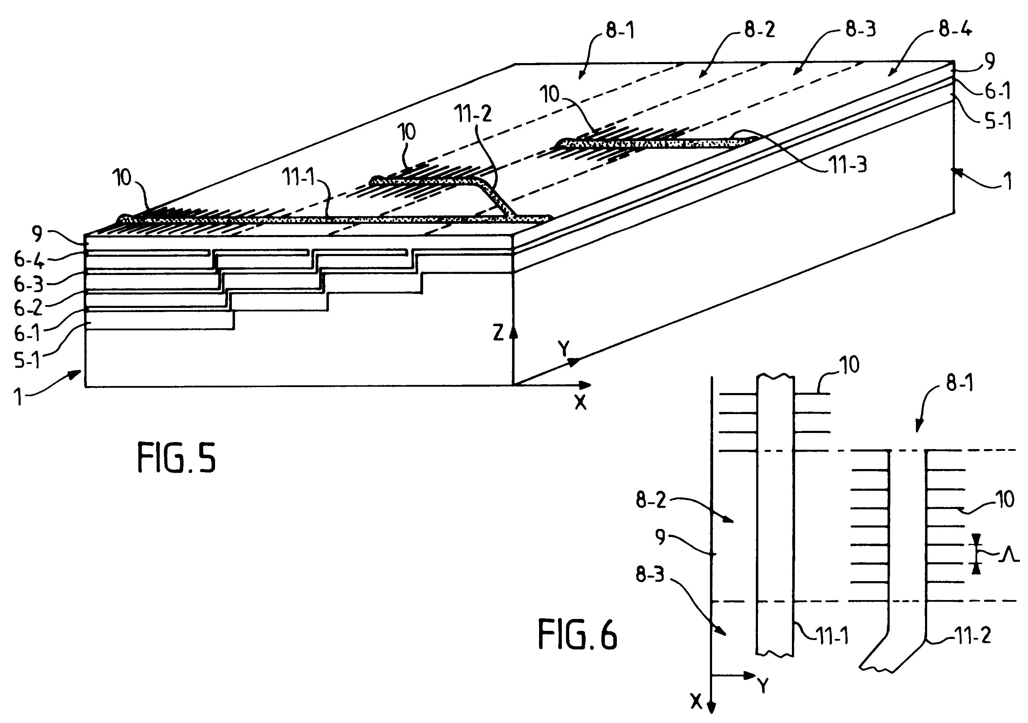

La description qui suit illustre la mise en oeuvre du procédé selon l'invention dans le cadre de l'obtention du dispositif optoélectronique semiconducteur illustré sur la figure 5. Un tel dispositif (ou composant) est susceptible d'émettre selon trois longueurs d'onde différentes ($\lambda 1$, $\lambda 2$ et $\lambda 3$), de guider les longueurs d'onde $\lambda 1$, $\lambda 2$ et $\lambda 3$, et enfin d'assurer un couplage entre les première $\lambda 1$ et seconde $\lambda 2$ longueurs d'onde.

Bien entendu, de très nombreux autres dispositifs peuvent être envisagés avec plus ou moins de fonctions que celles citées dans l'exemple, ou bien avec d'autres fonctions, comme par exemple des fonctions de détection ou bien de filtrage (par exemple par couplage de type évanescent) permettant d'effectuer des multiplexages ou des démultiplexages.

La première étape du procédé selon l'invention (voir figure 1) consiste en la transformation d'un substrat de forme parallélépipédique en un substrat 1 muni de marches. Ici, les marches présentent des hauteurs sensiblement identiques et délimitent un escalier. Bien entendu, d'autres structures, différentes d'un escalier, peuvent être envisagées (par exemple des marches de hauteurs différentes). Cela consiste à former dans le substrat un certain nombre i de marches 2-i (ici i=4) par attaque chimique humide ou sèche. Chaque marche 2-i comprend une face supérieure plane 3 sensiblement horizontale à la semelle inférieure 4 du substrat 1, et un bord 4 qui la relie à la face supérieure 3 de la marche inférieure, ou bien à la semelle (lorsqu'il s'agit de la toute première marche), ledit bord 4 étant sensiblement perpendiculaire à la face supérieure 3.

Afin de simplifier la description, on définit un système d'axes X, Y et Z, perpendiculaires entre eux. Dans ce repère, les faces supérieures 3 sont parallèles au plan X-Y, tandis que les bords de marches 4 sont parallèles au plan Y-Z.

Dans l'exemple décrit, le substrat est formé dans un matériau binaire du type InP (indium-phospore). Bien entendu, de nombreux autres matériaux semiconducteurs peuvent être envisagés pour former le substrat, selon les applications choisies, et plus particulièrement selon les longueurs de fonctionnement du composant.

La seconde étape du procédé selon l'invention (voir figure 2A et 2B) consiste à déposer des couples de couches semiconductrices sur les marches 2-i du substrat en escalier 1.

Chaque couple comprend une couche de confinement 5 qui supporte une couche active 6. Dans l'exemple illustré, étant donné que le substrat est formé dans un matériau binaire de type InP, il est particulièrement avantageux que les couches de confinement 5-i des paires de couches soient également dans un matériau de type InP. Les couches actives 6-i sont réalisées dans un matériau accordé en maille avec le matériau des couches de confinement. Il pourra s'agir, par exemple, d'un matériau quaternaire comme le GaInAsP (gallium-indium-arsenic-phosphore) dont les pourcentages des quatre constituants sont choisis en fonction des longueurs d'ondes de fonctionnement du composant à réaliser.

Bien entendu, on pourra utiliser un matériau ternaire pour former la couche active si les longueurs d'ondes de fonctionnement du composant l'imposent.

Il est préférable de faire croître les différentes couches de confinement et couches actives par épitaxie de type MOCVD.

Il est également préférable que les couches de confinement (ici en InP) des couples de couches soient de type n, et les couches actives (ici en GaInAsP) soient non dopées.

Dans l'exemple illustré, on fait croître ainsi quatre couples de couches (voir figure 2B) les unes au-dessus des autres. De préférence, l'épaisseur de la couche de confinement du premier couple (celui qui est déposé directement sur les marches 2-i du substrat 1), présente une épaisseur (suivant l'axe Z, dit axe de croissance) h1 sensiblement égale à la hauteur d'une marche 2, et par conséquent à la hauteur de son bord 4.

Les épaisseurs des couches des couples suivants (second à quatrième) sont choisies ici de sorte que la somme de l'épaisseur de la couche de confinement h2 et de l'épaisseur de la couche active h3 soit sensiblement égale à la hauteur h1 d'une marche 2-i. Ainsi, le profil en escalier du substrat 1 est conservé lors de la croissance des paires de couches.

A titre d'exemple, l'épaisseur des couches de confinement d'InP est sensiblement égale à 1 micromètre ($\mu$m), tandis que l'épaisseur des couches actives de quaternaire est sensiblement égale à 0,2 micromètre ($\mu$m).

De façon à permettre le fonctionnement du composant selon quatre longueurs d'ondes, les couches actives de chaque couple varient d'un couple à l'autre. A titre d'exemple, dans le matériau quaternaire GaInAsP, les proportions des quatre composants sont régies comme suit :

- $Ga_x\ In_{1-x}\ As_y\ P_{1-y}$, où x et y sont reliés par l'équation :

$$x = 0,1894\ y\ /\ (0,4184 - 0,0013\ y),$$

- avec $x \approx 0,47$ et $0 \le y \le 1$, pour assurer l'accord de maille sur le matériau binaire en InP.

C'est l'énergie de bande interdite Eg du matériau quaternaire, et par conséquent sa composition, qui détermine principalement la longueur d'onde d'émission laser de la couche active concernée. Ainsi, pour respecter l'accord de maille de GaInAsP sur InP, l'énergie de bande interdite Eg suit l'équation suivante :

$$Eg\ (eV) = 1,35 - 0,72\ y + 0,12\ y^2.$$

L'énergie de bande interdite Eg (ou gap), peut ainsi varier de environ 1,35 eV à 0,75 eV. Toutes ces relations, et différences d'énergie de bande interdite des matériaux semiconducteurs sont parfaitement connues de l'homme de l'art.

Par exemple, pour une largeur de bande interdite de 0,8 eV à laquelle est associée une longueur d'onde d'émission laser $\lambda_g = 1,55\ \mu$m, le composé quaternaire correspondant est $Ga_{0,413}\ In_{0,587}\ As_{0,884}\ P_{0,116}$. Pour un gap de 0,85 eV ($\lambda_g = 1,459\ \mu$m), le composé quaternaire correspondant est $Ga_{0,362}\ In_{0,638}\ As_{0,777}\ P_{0,223}$, et pour un gap de 0,9 eV ($\lambda_g = 1,378\ \mu$m), le composé quaternaire correspondant est $Ga_{0,316}\ In_{0,684}\ As_{0,681}\ P_{0,319}$.

L'un des objectifs du procédé selon l'invention est de délimiter des zones sensiblement parallèles les unes aux autres, et dans lesquelles l'indice optique effectif du matériau sous-jacent varie d'une zone à l'autre. Pour ce faire, le procédé selon l'invention comprend une troisième étape (voir figure 3) dans laquelle on effectue une planarisation de la structure en escalier de la figure 2B, en un niveau choisi de celle-ci. Cette planarisation s'effectue, dans l'exemple illustré, au niveau de la face supérieure de la première marche de la structure (la plus à droite sur la figure). Cette planarisation consiste en la suppression de l'ensemble des marches sur une hauteur H parallèle à l'axe Z, et par conséquent des couches qui se trouvent placées à un niveau supérieur à la face supérieure trois de cette première marche 2-1.

Cette suppression des couches s'effectue de façon sélective, de préférence par masquages successifs suivis d'attaques chimiques sélectives adaptées aux matériaux à supprimer (couche de confinement 5 et couche active 6).

Dans l'exemple illustré, une première solution, par exemple un mélange d'acide chlorhydrique (HCl) et de peroxyde d'hydrogène ($H_2O_2$) permet de dissoudre les couches de confinement en InP, et seulement ces couches, étant donné qu'il n'a aucun effet sur le GaInAsP. De même, une seconde solution, par exemple un mélange d'acide chlorhydrique (Hcl) et d'acide orthophosphorique ($H_3PO_4$) permet d'attaquer le matériau quaternaire en GaInAsP (ou s'il s'agit d'un matériau ternaire en GaInAs), et seulement celui-ci, sans s'attaquer aux couches de confinement en InP.

A la fin de la troisième étape (voir figure 3), la structure est subdivisée en zones 8-1 à 8-4 (matérialisées en pointillés pour faciliter la compréhension), sensiblement parallèles entre elles et respectivement superposées au-dessus des faces supérieures initiales 3 des marches 2-1 à 2-4. Ces zones se différencient les une des autres par le nombre de couches actives 6-i qui se trouvent empilées sur la marche 2-i correspondante. Ainsi, la première zone 8-1 comprend un empilement de 4 couches actives 6-1 à 6-4, la seconde zone 8-2 comprend un empilement de 3 couches actives 6-1 à 6-3, la troisième zone 8-3 comprend un empilement de deux couches actives 6-1 et 6-2 et la quatrième zone 8-4 comprend la seule couche active 6-1.

Ces différences de nombre de couches empilées et de compositions différentes des couches actives font que l'indice optique effectif des zones 8-i varie d'une zone à l'autre. Il en résulte, que chaque zone est susceptible d'émettre par effet laser à une longueur d'onde privilégiée si elle est couplée à un réseau de diffraction, et de préférence à un réseau de Bragg.

En effet, comme cela est parfaitement connu de l'homme de l'art, lorsque l'on forme au-dessus d'un empilement de couches actives et de confinement un réseau de type Bragg, cet empilement est susceptible d'effet laser à une longueur d'onde d'émission qui dépend du pas $\Lambda$ du réseau de Bragg, de l'indice optique effectif $n_{eff}$ du matériau qui se trouve placé sous le réseau (appelé également indice optique effectif du mode guidé), et de l'ordre de ce réseau m. Plus précisément, on a la relation :

$$\lambda = (2 * n_{eff} * \Lambda) / m$$

Une fois l'étape de planarisation terminée (voir figure 3), la structure, qui n'est pas encore le composant définitif, présente une surface supérieure plane 7 sensiblement parallèle à la semelle 4 du substrat 1. Il ne demeure plus alors de marche apparente dans cette structure. On peut alors passer à la quatrième étape du procédé selon l'invention.

Dans cette quatrième étape, on fait croître sur la surface supérieure plane 7 une couche terminale (ou supérieure) de matériau semiconducteur de confinement 9, de préférence de type p (voir figure 4). Cette couche est réalisée, de préférence, dans le même matériau que les couches de confinement 5, c'est-à-dire, dans cet exemple, en InP. Elle pourra être obtenue par épitaxie en phase vapeur (MOCVD), de manière à n'utiliser avantageusement qu'une seule technique de croissance pour tout le dispositif.

La cinquième étape du procédé selon l'invention (voir figures 5 et 6), consiste donc à réaliser dans la couche terminale 9 en une partie de l'une au moins des zones 8-i, un réseau de Bragg 10 de pas $\Lambda$, de sorte que cette partie de la zone soit susceptible d'émettre à une longueur d'onde qui dépend par la formule précitée de l'indice optique effectif du matériau qui la constitue. Cette émission laser s'effectue sensiblement perpendiculairement aux lignes parallèles qui forment le réseau de Bragg 10, lequel est ici parallèle (par ses lignes) à l'axe YY afin que la lumière laser se propage perpendiculairement aux bords des marches 4, c'est-à-dire parallèlement à l'axe XX.

Par ailleurs, pour qu'une lumière laser de longueur d'onde $\lambda i$ émise par une partie d'une zone 8-i puisse être guidée en sortie de ladite zone, il est impératif que les zones 8-j (j > i) qui suivent cette zone 8-i soient transparentes à la longueur d'onde $\lambda i$. En d'autres termes, il faut que les indices optiques effectifs des zones 8-j soient tous plus petit que celui de la zone 8-i. Dans l'exemple illustré sur la figure 5, les zones 8-1 à 8-4 présentent donc des indices optiques effectifs qui décroissent en partant de la première zone 8-1 vers la quatrième zone 8-4. Dans cette structure, on a donc $n1_{eff} > n2_{eff} > n3_{eff} > n4_{eff}$.

Etant donné que le réseau peut être localisé sur une partie seulement d'une zone, il est par conséquent possible, dans une autre partie de cette zone de guider une lumière de longueur d'onde plus grande.

Il est également possible, de réaliser dans une partie de la zone suivante, ici la seconde zone 8-2, non contiguë à la partie de la première zone 8-1 qui comprend le premier réseau de Bragg 10, de former lors de la cinquième étape un autre réseau de Bragg de même pas A que ledit premier réseau de Bragg, de sorte que la partie de la seconde zone 8-2 couplée à ce second réseau de Bragg 10 soit susceptible d'effet laser à une seconde longueur d'onde $\lambda 2$ strictement inférieure à $\lambda 1$.

On a également représenté sur la figure 5, en une partie de la troisième zone 8-3, non contiguë aux parties des première 8-1 et seconde 8-2 zones comportant un réseau de Bragg 10, et non alignées deux à deux selon l'axe XX, un troisième réseau de Bragg 10 destiné à permettre à la partie de cette troisième zone 8-3 d'émettre une lumière laser à une troisième longueur d'onde $\lambda 3$

strictement inférieure à λ2.

On pourrait prévoir de même dans la quatrième zone 8-4, en une partie non contiguë aux autres parties des zones précédentes (8-1 à 8-3) munies d'un réseau de Bragg, et non alignée avec l'une quelconque de ces parties suivant l'axe XX, un autre réseau de Bragg 10 de sorte que le composant puisse émettre à une quatrième longueur d'onde λ4 strictement inférieure à λ3.

Tous les réseaux de Bragg 10 peuvent être réalisés, grâce au procédé selon l'invention, en une seule et même étape (la cinquième), étant donné que le pas Λ de chaque réseau de Bragg 10 est le même.

Afin de pouvoir utiliser la lumière laser émise en chaque partie de zone 8-i, on forme au-dessus de la couche de surface supérieure 9 et, par conséquent au-dessus des réseaux de Bragg 10 des lignes de propagation 11-1 à 11-3. Ces lignes de propagation sont réalisées préférentiellement par un dépôt de GaInAsP, mais on peut également envisager de les réaliser à partir de matériaux synthétiques de type plastiques optiques comme par exemple les polyimides ou les polymères.

Les lignes de propagation 11-1 doivent, au moins au-dessus des réseaux de diffraction 10, être orientées sensiblement perpendiculairement (parallèlement à l'axe XX) aux lignes du réseau. En fait, il est possible d'orienter ces lignes à 90° plus ou moins environ 8°. Une désorientation par rapport à 90° entraîne une légère variation de la longueur d'onde. Au-delà du réseau de diffraction 10, les lignes de propagation peuvent être de forme quelconque, comme cela est le cas pour la ligne 11-2 de la figure 5, laquelle est recourbée en direction de la ligne 11-1 de façon à permettre au niveau de la quatrième zone 8-4 le couplage des lumières laser émises respectivement par les première 8-1 et seconde 8-2 zones.

Ainsi, comme cela est illustré sur les figures 5 et 6, le dispositif réalisé grâce au procédé selon l'invention, et qui est donné ici à titre d'exemple, permet non seulement d'émettre selon plusieurs longueurs d'onde, mais également de guider les différentes lumières émises en dehors des réseaux de Bragg de façon à les acheminer en des endroits choisis. Un tel dispositif permet donc d'intégrer de nombreuses fonctions optoélectroniques, comme par exemple l'émission laser multilongueurs d'onde, le guidage optique, le couplage de longueurs d'onde différentes, la détection, le filtrage, le multiplexage, le démultiplexage, l'amplification.

L'invention ne se limite pas au mode de réalisation décrit ci-avant en référence aux figures, mais elle englobe toutes les variantes que pourra développer l'homme de l'art dans le cadre des revendications ci-après.

Ainsi, le nombre de marches formées initialement pourra être inférieur à 4, comme par exemple égal à trois ou même à 2, ou bien supérieur à 4, selon l'application choisie, et plus précisément selon le nombre de longueurs d'ondes de fonctionnement du composant.

Par ailleurs, le dispositif selon l'invention pourra comprendre des lignes de propagation destinées à guider une longueur d'onde en provenance d'un élément ou composant externe, afin de l'acheminer au niveau d'un autre élément ou composant externe, ou bien de le coupler à une longueur d'onde d'une lumière laser produite par le dispositif réalisé selon l'invention.

D'autre part, on a décrit un dispositif dans lequel les couches de confinement et les couches actives étaient réalisées dans des matériaux respectivement binaires (de type InP) et quaternaires (de type GaInAsP), mais il est clair que de nombreux autres matériaux semiconducteurs peuvent être envisagés. On pourra notamment utiliser des matériaux ternaires de type GaInAs). De même, on pourra utiliser d'autres substrats que les substrats en matériaux binaires de type InP, selon les matériaux utilisés pour former les couches de confinement et les couches actives, et par conséquent selon les longueurs d'onde de fonctionnement du dispositif.

De plus, dans la description, il est précisé qu'il est préférable de faire croître les différentes couches de confinement et couches actives par des épitaxies MOCVD, lesquelles offrent l'avantage d'être effectuées à pression atmosphérique, mais il est clair que d'autres techniques de croissance pourront être envisagées. Il en va de même des solutions chimiques citées à titre d'exemple dans la description, et utilisées pour les différentes attaques chimiques des couches de confinement et des couches actives.

Enfin, dans la description qui précède on a représenté une structure dans laquelle le substrat comprend des marches formant un escalier classique. Mais, selon les applications choisies on peut envisager un substrat dans lequel les marches successives délimitent des niveaux qui ne sont pas tous systématiquement placés les uns au dessus (ou au dessous) des autres. De même, les hauteurs respectives des différentes marches pourront varier d'une marche à une autre.

## Revendications

1. Procédé de fabrication d'un dispositif semiconducteur, caractérisé en ce qu'il comprend en combinaison les étapes suivantes :

    - réaliser dans un substrat semiconducteur (1) une multiplicité de marches (2-i), de dimensions adaptées, munies de faces supérieures (3) parallèles entre elles et reliées entre elles par des bords (4) sensiblement perpendiculaires auxdites faces supérieures,
    - faire croître sur le substrat muni de marches (1), en une première épitaxie, un empilement d'au moins des premier et second couples de couches semiconductrices de confinement (5-i) et active (6-i), dans cet ordre, les couches actives possédant des énergies de bande interdite (Eg) différentes d'un couple à l'autre,

-   planariser ledit empilement en un niveau choisi de façon à former une surface supérieure plane (7), parallèle aux faces supérieures (3) des marches (2-i), et à créer localement dans l'empilement des zones (8-i) d'indices optiques effectifs différents choisis, sensiblement parallèles entre elles et respectivement superposables aux faces supérieures des marches,

-   faire croître sur la surface supérieure (7), en une seconde épitaxie, une couche semiconductrice terminale de confinement (9), de type p,

-   réaliser dans la couche terminale de confinement (9), au niveau d'une partie au moins d'une première zone choisie (8-1), un réseau de diffraction (10) de pas ($\Lambda$) choisi et parallèle aux bords des marches (4), de sorte que ladite partie de la première zone (8-1) soit susceptible d'effet laser à une première longueur d'onde ($\lambda1$), fonction de son indice optique effectif ($n_{eff}$), et

-   déposer sur la couche terminale (9) au moins une première ligne de propagation (11-i) présentant au moins au dessus de la partie de la zone choisie une direction sensiblement perpendiculaire au réseau de diffraction (10).

**2.** Procédé selon la revendication 1, caractérisé en ce que le réseau de diffraction (10) est un réseau dit "de Bragg".

**3.** Procédé selon l'une des revendications 1 et 2, caractérisé en ce qu'au moins la première épitaxie est réalisée en phase vapeur.

**4.** Procédé selon l'une des revendications 1 à 3, caractérisé en ce que la planarisation s'effectue par attaques chimiques sélectives des couches de confinement (5-i) et des couches actives (6-i).

**5.** Procédé selon l'une des revendications 1 à 4, caractérisé en ce que les couches actives (5-i) présentent respectivement des énergies de bande interdite qui sont d'autant plus petites que la distance qui les sépare du substrat est grande.

**6.** Procédé selon l'une des revendications 1 à 5, caractérisé en ce que la couche terminale de confinement (9) est déposée au niveau des couches actives (6-i).

**7.** Procédé selon l'une des revendications 1 à 6, caractérisé en ce que les couches de confinement (5-i) des paires de couches sont de type n.

**8.** Procédé selon l'une des revendications 1 à 7, caractérisé en ce que les couches de confinement (5-i,9) sont réalisées dans un matériau binaire, de type InP.

**9.** Procédé selon l'une des revendications 1 à 8, caractérisé en ce que les couches actives (6-i) sont réalisées dans un matériau quaternaire accordé en maille avec ledit matériau formant les couches de confinement (5-i), de type GaInAsP, lesdites proportions respectives des quatre constituants (Ga,In, As,P) du matériau quaternaire variant d'une paire à l'autre et étant choisies de façon à permettre des effets laser à des longueurs d'onde différentes.

**10.** Procédé selon l'une des revendications 1 à 9, caractérisé en ce que le substrat (1) est réalisé dans un matériau binaire, de type InP.

**11.** Procédé selon l'une des revendications 1 à 10, caractérisé en ce qu'un autre réseau de diffraction (10), de mêmes pas ($\Lambda$) et orientation que le premier réseau, est formé en au moins une partie d'une seconde zone choisie (8-2), non contiguë à la partie de la première zone choisie, non alignée selon la direction perpendiculaire aux bords (4) de marches avec la partie de la première zone (8-1) contenant un réseau de diffraction (10), et susceptible d'effet laser à une seconde longueur d'onde ($\lambda2$), et en ce que l'étape de dépôt sur la couche terminale (9) comprend la réalisation d'une seconde ligne de propagation (11-2) présentant au moins au dessus de la partie de la seconde zone choisie (8-2) une direction sensiblement perpendiculaire au réseau de diffraction (10).

**12.** Procédé selon l'une des revendications 1 à 11, caractérisé en ce que les dimensions des marches sont adaptées en fonction du dispositif envisagé.

FIG.1

FIG.2A

FIG.2B

FIG.3

FIG.4

FIG.5

FIG.6

**RAPPORT DE RECHERCHE EUROPEENNE**

Numéro de la demande

EP 98 40 0933

## DOCUMENTS CONSIDERES COMME PERTINENTS

| Categorie | Citation du document avec indication, en cas de besoin. des parties pertinentes | Revendication concernée | CLASSEMENT DE LA DEMANDE (Int.Cl.6) |
|---|---|---|---|
| A | EP 0 380 380 A (FRANCE ETAT) 1 août 1990 <br> * colonne 6, ligne 50 - colonne 13, ligne 58; figures 7-11 * <br> --- | 1,3-12 | H01S3/25 <br> H01S3/085 |
| D,A | DE 44 42 640 A (FRANCE TELECOM) 8 juin 1995 <br> * figure 1 * <br> --- | 1,2,11 | |
| A | DELORME F ET AL: "SIMPLE MULTIWAVELENGTH DEVICE FABRICATION TECHNIQUE USING A SINGLE- GRATING HOLOGRAPHIC EXPOSURE" <br> IEEE PHOTONICS TECHNOLOGY LETTERS, <br> vol. 8, no. 7, 1 juillet 1996, pages 867-869, XP000595605 <br> * figure 1 * <br> --- | 1,2,11 | |
| A | EP 0 667 660 A (FRANCE TELECOM) 16 août 1995 <br> * le document en entier * <br> ----- | 1,2,11 | |

DOMAINES TECHNIQUES RECHERCHES (Int.Cl.6)

H01S

Le présent rapport a été établi pour toutes les revendications

| Lieu de la recherche | Date d'achèvement de la recherche | Examinateur |
|---|---|---|
| LA HAYE | 30 juillet 1998 | Claessen, L |